Europäisches Patentamt

European Patent Office

Office européen des brevets

(11) Publication number: **0 228 673**
**A2**

## (12) EUROPEAN PATENT APPLICATION

(21) Application number: 86117693.1

(22) Date of filing: 18.12.86

(51) Int. Cl.⁴: **H05K 13/02** , H05K 13/00

(30) Priority: 07.01.86 US 816728

(43) Date of publication of application:
15.07.87 Bulletin 87/29

(84) Designated Contracting States:
DE FR NL

(71) Applicant: ITT INDUSTRIES INC.
320 Park Avenue
New York, NY 10022(US)

(72) Inventor: Vanden Broeke, Johannes
5 Barrington Drive
Andover Massachusetts 01810(US)

(74) Representative: Morstadt, Volker, Dipl.-Ing. et
al
c/o Deutsche ITT Industries GmbH
Patent/Lizenzabteilung Postfach 840
Hans-Bunte-Strasse 19
D-7800 Freiburg/Brsg.(DE)

(54) Electronic device carrier tape assembly and cartridge utilizing the same.

(57) There is disclosed a carrier tape assembly to facilitate the transporting of electronic devices. The assembly includes an elongated web of flexible material, the web including a plurality of longitudinally spaced cavities formed therein for receiving the devices and wherein the cavities have a transverse width dimension. The carrier tape assembly further includes retaining means extending longitudinally over the cavities for retaining the devices within the cavities wherein the retaining means has a transverse width dimension which is less than the transverse width dimension of the cavities. Also disclosed is a cartridge assembly adapted to house the carrier tape assembly and act upon the carrier tape assembly for presenting the devices one at a time for removal.

FIG.I

## Electronic Device Carrier Tape Assembly and Cartridge utilizing the same

### Background of the Invention

The present invention relates to carrier tape assemblies to facilitate the transporting of electronic devices and more particularly to such an assembly for transporting electronic devices of the type which include external terminals. The present invention further relates to a cartridge assembly adapted to house and act upon the carrier tape assembly to controllably present the devices one at a time for removal from the carrier tape assembly.

In the manufacture of electronic circuits, printed circuit boards are often used. As well known, printed circuit boards include a predefined metal lead pattern and holes or terminals for receiving electronic components or devices therein. Such devices must necessarily include external terminals for making electrical contact with the printed circuit board circuit pattern. The devices can take the form of, for example, metal electrode face bonded surface mountable devices which can have a cylindrical configuration, such as, diodes, resistors, or capacitors. Such devices can also be small out-line transistors which are formed from plastic, are rectangular in configuration, and include external contacts for surface mounting. Also, such devices are generally quite small in size to take full advantage of the high circuit densities afforded by printed circuit boards.

The foregoing presents at least two problems to the device manufacturer who supplies electronic devices to electronic circuit manufacturers. The first problem relates to shipping large quantities of the devices in a manner which precludes the devices from being lost in shipment. The other problem relates to housing the devices so that they can be readily utilized by the circuit manufacturer.

In the prior art, the above noted problems have at least partially been overcome by the transporting of the devices in carrier tapes which include an elongated web of embossed plastic material. The tapes include a plurality of cavities longitudinally spaced along the tapes wherein each cavity is dimensioned for receiving one of the devices. A plastic heat sealing cover tape covers the entire carrier tape across its full width to retain the devices within the carrier tape cavities.

The foregoing carrier tapes, while being at least partially successful, have exhibited some disadvantages. For example, once the devices are retained within the carrier tapes by the heat sealed cover, it is then impossible to electrically test the devices. Associated with the inability to electrically test the devices is the inability to replace defective devices once sealed in the carrier tape. With prior art carrier tapes it is also impossible to fill empty cavities should one of the cavities inadvertently not receive a device therein. Also, it has been found that the adherence of the heat sealing cover to the carrier tape is not always uniform so that upon stripping the heat sealed cover from the carrier tape, vibrations are set up in the tape causing occasional popping out of the devices when the devices are to be utilized by the circuit manufacturer. Lastly, the heat sealing of the cover tape to the carrier has been a high cost process resulting in the packaging of the devices representing a significant portion of the overall cost in providing the devices to the circuit manufacturer.

As a result of the foregoing, there is a need for a new and improved carrier tape assembly to facilitate the transporting of electronic devices. More particularly, there is a need for such a carrier tape assembly which can represent a significantly lower cost in providing the devices to the circuit manufacturer and which permits electrical testing and replacement of bad devices and the filling of empty cavities. There is a still further need for such an improved carrier tape assembly which can be readily used by the circuit manufacturer and which avoids inadvertent or occassional popping out of the devices when so utilized.

### Summary of the Invention

The present invention therefore provides a carrier tape assembly to facilitate the transporting of electronic devices. The assembly includes an elongated web of flexible material, the web including a plurality of longitudinally spaced cavities formed therein for receiving the devices and wherein the cavities have a transverse width dimension. The carrier tape assembly further includes retaining means extending longitudinally over the cavities for retaining the devices within the cavities wherein the retaining means has a transverse width dimension which is less than the transverse width dimension of the cavities.

The present invention further provides a cartridge assembly to facilitate the transporting of electronic devices and the presenting of the devices for removal. The assembly includes a housing, a flexible web within the housing wherein the web is elongated and wound in a roll, wherein the web has a plurality of longitudinally spaced cavities formed therein for receiving the devices, and wherein the cavities have a transverse dimension. The web further includes a retaining means extending longitudinally over the cavities for retaining the devices within the cavities wherein the retaining means has a transverse width dimension which is less than the transverse width dimension of the cavities. The cartridge assembly further includes stripping means carried by the housing for removing the retaining means from the web to present the devices for removal from the cavities.

## Brief Description of the Drawings

Fig. 1 is a partial top plan view of a carrier tape assembly embodying the present invention;

Fig. 2 is a cross-sectional view taken along lines 2-2 of Fig. 1;

Fig. 3 is a side view of a cartridge assembly embodying the present invention; and

Fig. 4 is a partial side view of a portion of the cartridge assembly of Fig. 3 drawn to an enlarged scale.

## Detailed Description

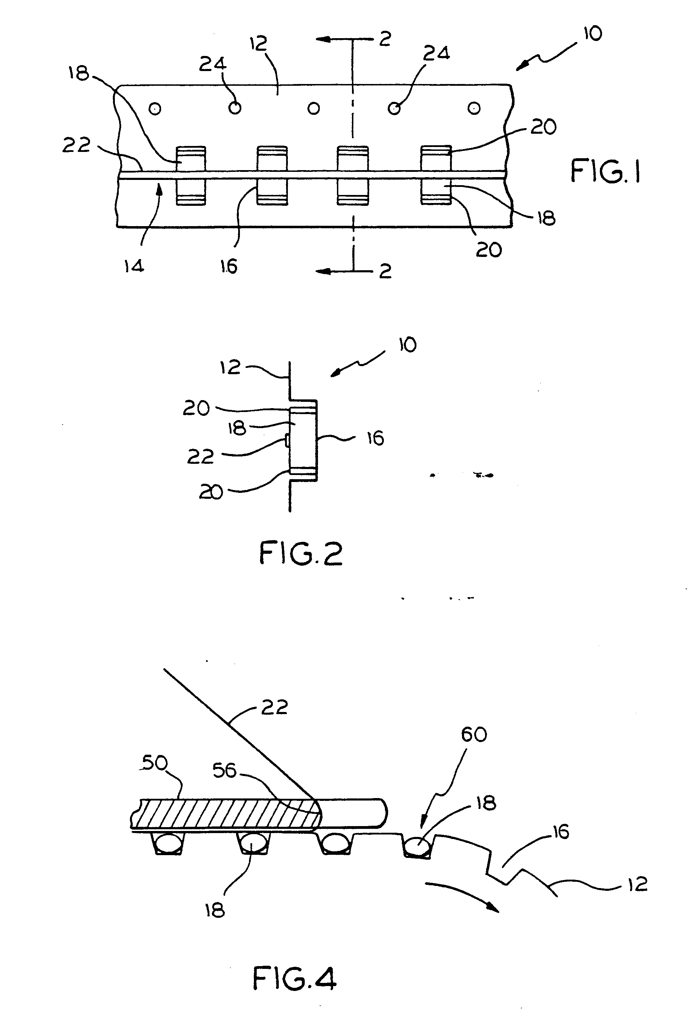

Referring now to Figs. 1 and 2, they illustrate a carrier tape assembly 10 embodying the present invention. The assembly generally includes an elongated web of flexible material 12 and a retaining means 14. The elongated web 12 includes a plurality of longitudinally spaced cavities 16 which are dimensioned for receiving the devices 18 therein. As can be noted from the figure, the cavities 16 have a transverse dimension.

The devices 18 are of the type which include external terminals 20. To that end, the devices 20 can be, for example, diodes, resistors, or capacitors.

The retaining means 14 is preferably an elongated strip of flexible material 22. The strip 22 preferably includes an adhesive on the side thereof which contacts the web 12 and has a transverse width dimension which is less than the transverse width dimension of the cavities 16. As can also be noted in the figure, the strip 22 is positioned over the cavities to expose the external terminals 20 of the devices 18. This facilitates testing of the devices while the devices are retained within the cavities and also the replacement of defective devices before the carrier tape assembly 10 is shipped to a circuit manufacturer.

Because the strip 22 has a small width dimension compared to the transverse width dimension of the cavities 16 and the web 12, uniform adherence of the strip 22 can be maintained with the web 12. This facilitates removal of the strip, as by pealing or stripping for example, without imparting vibrations to the web 12 which would otherwise cause the devices 18 to occassionally and inadvertently pop out of their respective cavities 16. In addition, the strip 22 can be of a certain color which is different than the color of the strip on other carrier assemblies such that the type of device 18 contained within the carrier assembly 10 can be readily ascertained.

The web 12, as previously mentioned, is preferably formed from a flexible material. Polymer based plastics such as polyvinyl chloride or polyethylene are suitable materials for forming the web 12. The strip 22 is also preferably formed from a flexible material and can be made much thinner than the web 12. The strip 22 can be formed from, for example, cellulose nitrate.

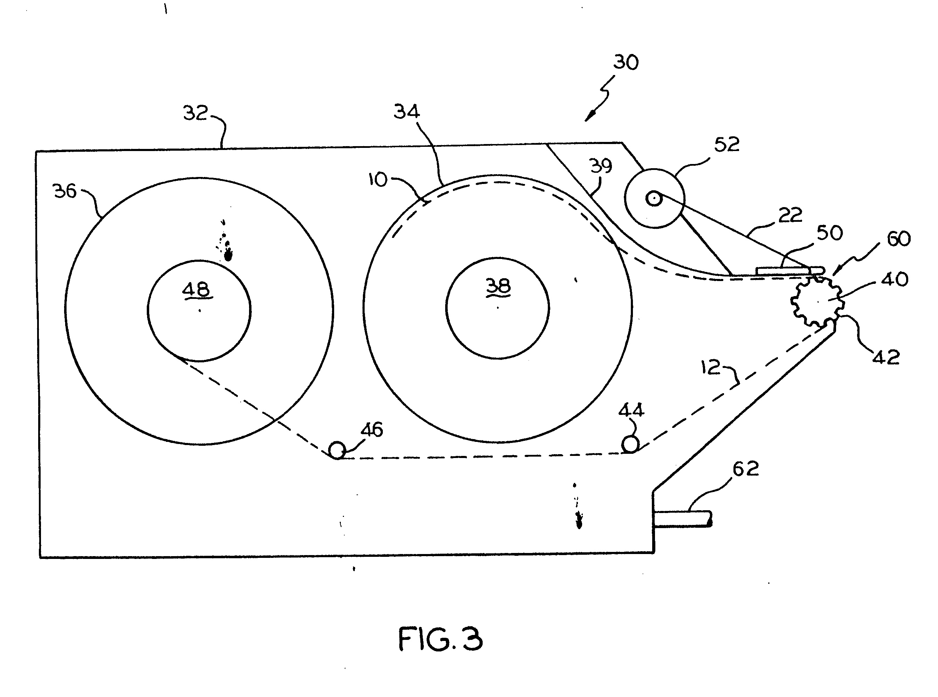

Referring now to Fig. 3, it illustrates a cartridge assembly 30 embodying the present invention. The cartridge assembly 30 includes a housing 32, a carrier tape supply reel 34, and a take-up reel 36. The supply reel 34 includes a spool 38 which has the carrier tape 10 as shown in Fig. 1 wound thereabout. The housing 32 includes a guide wall 39 which guides the carrier tape 10 to an advance sprocket wheel 40. The wheel 40 includes a plurality of sprocket teeth 42 arranged to engage sprocket holes 24 which, as best seen in Fig. 1, are longitudinally spaced along an edge portion of the web 12.

The housing 32 further includes a pair of guide pins 44 and 46 which guide the web 12 from which the devices have been removed to a spool 48 of the take-up reel 36. The housing 32 further includes a stripper plate 50 and a strip take-up reel 52. As can be noted in the figure, the guide wall 39 guides the web 12 under the stripper plate 50 whereat the retaining means strip 22 is pealed back from the web 12 over an edge of the stripping plate.

Referring to Fig. 4 for a moment, it can be seen that the stripping plate 50 includes an extension 52. The extension 52 is formed by a notch or groove 54 formed in the end of the stripping plate 50. The groove 54 preferably has a width dimension which is slightly greater than the transverse width dimension of the strip 22 to control the lateral displacement of the strip 22 as it is pealed back from the web 12 by the edge 56 of the stripper plate 50. The extension 52 serves to hold the web 12 down as the strip 22 is removed therefrom to assure that the devices 18 do not inadvertently pop out of the cavities 16 when the strip 22 is stripped away from the web 12. Once the strip 22 is stripped from the web 12 and the device 18 adjacent the edge 56 moves beyond the extension 52, the device is ready to be removed from the cavity at a removal position 60.

Referring again to Fig. 3, the cartridge 30 further includes an actuator 62. The depression of the actuator 62 causes an appropriate gear assembly - (not shown) to drive the sprocket wheel 40 and thus the web 12 by a distance substantially equal to the distance between adjacent cavities. As a result, each operation of the actuator 62 presents a new uncovered device 18 for removal at the removal position 60.

As can be seen from the foregoing, the present invention provides a new and improved carrier tape assem bly which facilitates the transportation of electronic devices. The invention further provides an improved cartridge assembly which facilitates the transportation of electric devices and the presenting of the devices for removal by an operator.

## Claims

1. A carrier tape assembly (10) to facilitate the transporting of electronic devices (18), the assembly comprising:
an elongated web (12) of flexible material, the web (12) including a plurality of longitudinally spaced cavities (16) formed therein for receiving the devices (18), the cavities (16) having a transverse width dimension; and
retaining means (14) extending longitudinally over the cavities (16) for retaining the devices (18) within the cavities (16), for retaining means (14) having a transverse width dimension which is less than the transverse width dimension of the cavities (16).

2. An assembly as defined in claim 1 including a spool (38) around which the web (12) is wound.

3. A cartridge assembly (30) to facilitate the transporting of electronic devices (18) and the presenting them for removal, the assembly (30) comprising:
-a housing (32)
-a flexible web (12) within the housing (32), the web (12) being elongated and wound in a roll and having a plurality of longitudinally spaced cavities - (16) formed therein for receiving the devices (18), the cavities (16) having a transverse dimension, and retaining means (14) extending longitudinally over the cavities (16) for retaining the devices (18) therein and having a transverse width dimension which is less than the transverse width dimension of the cavities; and
-stripping means carried by the housing (32) for removing the retaining means (14) from the web - (12) to present the devices (18) for removal from the cavities (16).

4. An assembly as defined in claim 3 including a first take-up reel (36) within the housing (32) for gathering the web (12) and a second take-up reel - (52) for gathering the means (14) after said devices (18) are removed from said cavities (16).

5. An assembly as defined in claim 3 or 4 wherein the web (12) includes drive sprocket holes (24) along an edge portion of the web, and wherein the assembly includes a drive sprocket having teeth (42) to engage the sprocket holes (24) for advancing the web and actuating means for advancing the drive sprocket and the web (12) by a distance substantially equal to the distance between adjacent cavities (16) upon each operation of the actuating means to present each device (18) for removal one at a time.

6. An assembly as defined in anyone of the claims 3 to 5 wherein the stripping means comprises a stripper plate (50) arranged for receiving the web (12) there beneath.

7. An assembly as defined in claim 6 wherein the stripper plate (50) includes a groove (54) having a transverse width dimension which is slightly greater than the transverse width dimension of the retaining means (14).

8. An assembly as defined in claim 6 or 7 wherein the stripping means includes an extension (52) for holding the web (12) as the retaining means (14) is removed therefrom.

9. An assembly as defined in anyone of claims 1 to 8 wherein the devices (18) are of the type having external terminals (20) and wherein the retaining means (14) is positioned over the cavities - (16) to expose the external terminals (20) of the devices (18) to facilitate testing of them while they are retained within the cavities (16).

10. An assembly as defined in claim 9 wherein the retaining means (14) comprises an elongated strip (22) of flexible material.

11. An assembly as defined in claim 10 wherein the elongated strip (22) includes an adhesive on the side thereof which contacts the web (12).

12. An assembly as defined in claim 11 wherein the adhesive is adapted to releasably adhere the strip (22) to the web (12) to permit the strip (22) to be pulled from the web (12) to thereby facilitate removal of the devices (18) from the cavities (16).

13. An assembly as defined in anyone of claims 10 to 12 wherein the strip (22) is of a selected color corresponding to the type of devices (18) retained within the cavities (16).

FIG.1

FIG.2

FIG.4

FIG.3

0 228 673